# EUROPEAN PATENT SPECIFICATION

(11) **EP 2 399 373 B1**
(45) Date of publication and mention of the grant of the patent: **20.04.2016**
(21) Application number: 09776385.8
(22) Date of filing: 17.02.2009
(51) Int. Cl.: H04L 25/49, H03M 5/12

(54) **METHOD FOR DECODING MANCHESTER CODE**
VERFAHREN ZUM DECODIEREN VON MANCHESTER-CODE
PROCÉDÉ DE DÉCODAGE DE CODE MANCHESTER

(43) Date of publication of application: 28.12.2011
(73) Proprietor: ThyssenKrupp Presta AG, 9492 Eschen (LI)
(72) Inventor: HODOSSY, Sandor, 9900 Körmend (HU); TURMEZEI, Peter, 1124 Budapest (HU)
(74) Representative: Lenzing, Andreas
(86) International application number: PCT/EP2009/001112
(87) International publication number: WO 2010/094296

(56) References cited:
- EP-A1- 1 347 609
- US-B1- 6 963 295
- JIMENEZ J ET AL: "Manchester Decoding Algorithm For Multifunction Vehicle Bus" INDUSTRIAL TECHNOLOGY, 2004. IEEE ICIT '04. 2004 IEEE INTERNATIONAL CO NFERENCE ON HAMMAMET, TUNSIA DEC. 8-10, 2004, PISCATAWAY, NJ, USA,IEEE, vol. 2, 8 December 2004 (2004-12-08), pages 769-774, XP010822137 ISBN: 978-0-7803-8662-4

## Description

### Background of the invention

The present invention relates to a method for decoding Manchester code and to the use of such method for decoding sensor signals in electric power assisted steering systems.

In telecommunication, Manchester code is a line code in which the encoding of each data bit has at least one transition and occupies the same time interval. Essentially, the code is generated by combining the data signal and a clock signal in an XOR operation. It is, therefore, self-clocking, which means that the clock signal can be recovered from the encoded data. Manchester code is also known as Phase Encoding.

It is widely used, for example in the Ethernet. Advantages of the Manchester code are simple encoding with no longer period without a level transition, which helps to recover the clock signal. Furthermore, there is no necessity to transfer a DC-component with the encoded signal. Shortcomings of Manchester code are the necessity to provide twice the bandwidth of asynchronous communications and that the signal spectrum is much wider. This shortcoming is usually no problem in automotive applications since the signal rates are relatively low. Another important shortcoming is that errors in the synchronization of the receiver and the transmitter are critical to avoid errors. A half-bit period error already gives an inverted output at the receiver which needs to be checked and corrected.

### Description of the related art

In the prior art, US-patents US 5,187,546, US 5,815,089 and

US 4,409,656 show the use of Manchester encoding and decoding without disclosing a method for decoding the Manchester code. In US 4,631,519, the lengths of the pulses of the Manchester code are measured and the pulse width is determined from minimizing the error using the least squares method. Nothing is said about decoding the signal.

WO 2002/001160 discloses a position sensor which uses Manchester code. Nothing is said about decoding the signal.

The publication "Manchester decoding algorithm for Multifunction Vehicle Bus", authored by J. Jiménez et. al., published in 2004 IEEE International Conference on Industrial Technology (ICIT), pages 769 - 772, describes a decoder that waits until a start bit is detected. After that, it identifies the start delimiter as "slave" or "master". Next, the data frame must be decoded. For this purpose, the line is continuously oversampled in order to determine the location of the edges with an accuracy of the sampling period.

EP 1 347 609 A1 describes a method and an apparatus for decoding binary Manchester-encoded signals comprising bit central and bit initial transitions, the method comprising among other steps the steps of generating a local clock signal, determining the central transitions and measuring, by means of the local clock signal, the time interval elapsing between a pair of adjacent central transitions.

US 6,963,295 B1 describes a method of recovering and decoding of Manchester coded data by comparing the time period from the start of a bit to the first falling edge with the time period from the last rising edge to the end point of the bit.

It is therefore an object of the present invention to provide a method to decode Manchester code which is more tolerant to timing errors, deviation and comparator offset. Furthermore, it is an object of the present invention to provide an electric servo assisted steering system in which a sensor provides Manchester code which is decoded with an improved error tolerance.

This object is achieved by a method of claim 1 and by the electric steering system of claim 8. The depending claims describe improvements of the invention.

By using the method of claim 1, namely the method of decoding a digital signal which is encoded as a code sequence in Manchester code and which is submitted as a sequence of frames by a data source and received by a decoder, in which the decoder distinguishes between the high state and the low state of the signal by synchronizing itself both for the high halfbit and the low halfbit during the period of two start bits of the frame, and in which the times t1, t2 which are calculated during the synchronization are used during the interpretation of the following bits of the frame, where t1 denotes the first duration time between a first signal level change and a second signal level change, the first and the second signal level change being in opposite directions, and where t2 denotes the second duration time between the second signal level change and a third signal level change in opposite directions, the second and the third signal level change being in opposite directions, wherein the method comprises the following steps:
a) determine the first duration time (t1) determine the second duration time (t2) based on the two start bits,
b) compare the first duration time (t1) of step a) with a preset time first value (T1) and the second duration time (t2) with a preset time second value (T2)
c)
   i) if the first duration time (t1) differs from the first values (T1) by more than a first threshold (dt1), and/or if the second duration time (t2) differs from the second values (T2) by more than a second threshold (dt2), then set an error flag, discard the present code sequence and request a new code sequence to be submitted from the data source, or
   ii) if the first duration time (t1) differs from the first values (T1) by less than a first threshold (dt1), and/or if the second duration time (t2) differs from the second values (T2) by less than a second threshold (dt2), then the present code sequence will be accepted and decoded according to the Manchester code which is used for encoding, and after the acceptance of the code sequence, the preset time value (T1, T2) is replaced by the corresponding duration time (t1, t2) which was determined in step a), and a new code sequence is requested from the data source and
d) proceed with step a),
a safe and error tolerant decoding process is ensured and the decoding process is not affected by duty cycles which differ from the standard value of 50%. This is further improved by a process in which for each time between a first signal level change from a first to a second signal level is determined a first duration time (t1) and for each time between the second signal level change and a third signal level change is determined a second duration time (t2) and followed by the steps b) and c) as mentioned above for each estimated duration time.

In this way, deviations from the ideal signal in bit time, half bit time and comparator offset do not necessarily lead to a decoding error. A dynamic adaptation to environmental or systemic influences is possible because in step cii), after the acceptance of the code sequence, the preset time value (T1, T2) is replaced by the corresponding duration time (t1, t2) which was determined in step a).

If an error is detected and the associated erroneous code sequence is discarded, a new code sequence will be requested. It may be preferred if in this case the method requests the same sequence as the one that was discarded at least once.

As an alternative it is also possible instead of requesting the next code sequence to omit the failure detected code sequence and expect the next sequence. This is using in cases for getting streaming data in a kind of continuous communication.

It is preferred that in step c), the first and/or second threshold (dt1, dt2) is in the range of 0 to 1/4 of the corresponding preset time value (T1, T2), preferably 0 to 1/6 of the corresponding preset time value (T1, T2) which gives a relatively broad window to accept the coded signal and to adapt the preset values dynamically.

It may also be preferred that in step c), the first and/or second threshold (dt1, dt2) is in the range of 0 to 1/10 of the corresponding preset time value (T1, T2). This increases the rejection rate but provides a safer decoding process.

Another set of parameter, which may be advantageous, provides that in step c), for values of duration time (t1, t2) < corresponding preset time value (T1, T2), the corresponding threshold (dt1, dt2) is in the range of 0 to 1/4 of the corresponding preset time value (T1, T2), preferably 0 to 1/6 of the corresponding preset time value (T1, T2), and for values of duration time (t1, t2) > corresponding preset time value (T1, T2), the threshold (dt1, dt2) is in the range of 0 to the corresponding preset time value (T1, T2), preferably 0 to 1/2 of the corresponding preset time value (T1, T2), and more preferably 0 to 1/4 of the corresponding preset time value (T1, T2).

As an improvement it is also possible and included by this invention to use in case of acceptance of the code sequence the sliding average of a number of successive measured first and/or second duration times (t1, t2) to determine the new preset first and/or second time value (T1, T2). This sliding average can build up for a sequence in one or more code sequences. It is as an alternative also possible to use the first three signal level changes of each frame to build up the new preset time value (T1, T2) only. As advantages such preset time value is build up or construct as result of three or better seven following accepted measurement results for first and/or second duration times (t1, t2).

Preferably, decoding the Manchester signal is carried out in a device with a memory, signal input means, signal output means and a micro processor or a FPGA or ASIC, for the execution of the method according to the steps mentioned above.

A preferred embodiment is an electric steering system in which a signal is Manchester encoded and decoded according to the steps mentioned above or using the device mentioned above, in which the signal is a torque signal from a torque sensor or an angular signal from a rotation angle sensor.

### Description of the drawings

A preferred embodiment of the present invention is described with reference to the drawings, in which
Fig. 1 is a block diagram of the signal chain from the input device to the output device;
Fig. 2 is a block diagram like fig. 1 in an electric power assisted steering system;
Fig. 3 is a representation of the inputs and outputs which are used to implement the method in the signal chain of fig. 1; and
Fig. 4 is a representation of the different states of the method in the form of a state machine.

### Detailed description of the drawings

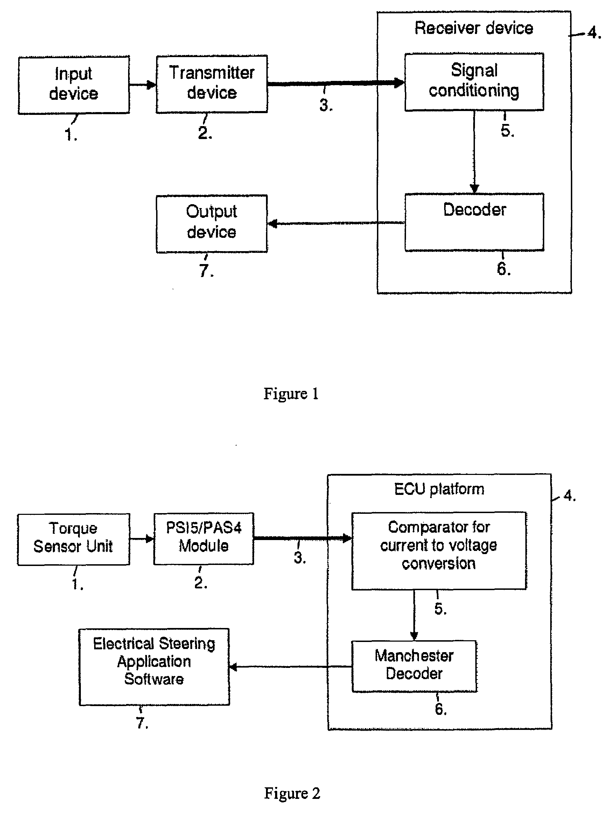

Fig. 1 shows a block diagram of the signal chain in which the present method is used, in general terms. Fig. 2 shows the block diagram in an application to an electric power assisted steering system, in which the torque sensor signal is Manchester encoded and decoded according to the present invention.

An input device 1 receives an input, for example a mechanical value and generates a corresponding electric signal. This signal is transferred to a transmitter device 2, which encodes the information to a digital signal in order to transmit it in a robust way to an electronic control unit (ECU). The encoding process is such that the edge direction of the signal at predefined time positions carries the information. This is done by conventional Manchester encoding. The transmitter device 2 is also adapted to transmit the encoded information through a channel 3, i.e. through wires. A receiver 4 includes a signal conditioning block 5 which prepares a signal for decoding and a decoder block 6 which translates the information to a different protocol. The translated information is passed to an output device 7.

The receiver 4 is an ECU in which the signal conditioning module 5 performs a current-to-voltage conversion. The decoder 6 is a Manchester decoder which decodes the signal from the signal conditioning device 5 according to the method of the present invention. The output of the decoder is a known UART-communication signal. The output device 7 is an electronic device which uses the signal from the input device for a necessary output signal. This electronic device can be a device with microcontroller, memory and further components, running application software for the calculation of the values for output signals. Such device with microcontroller can be also an FPGA or an ASIC. For example, if the input device is a torque sensor unit of an electric power assisted steering, the application software 7 generates a signal to adjust the necessary assist torque which is generated by a servo motor. It was also possible that the output device 7 is an integral part of the receiver 4.

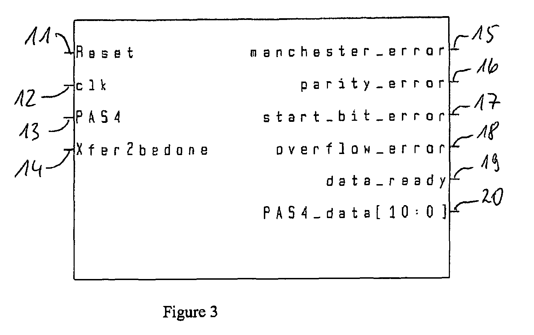

Fig. 3 represents the input and output signals of the decoder 6 of figs. 1 and 2. The necessary inputs to the decoder are represented on the left side of the block. The signals are a reset 11, a clock signal 12, a data input signal 13 which is called PAS4 in this embodiment, and a transfer signal 14 which indicates the necessity to transfer data.
The output signals on the other hand are listed on the right hand side of the decoder block 6. The signals comprise a group of error signals, namely Manchester error 15, parity error 16, start bit error 17 and overflow error 18. Furthermore, a data ready signal 19 is provided. Finally, the decoded data signal 20 is generated on the output side. This signal is the input for the output device 7 in fig. 1.

Reset 11 and clock signal 12 control the functioning of the decoder, transfer signal 14 and data ready signal 19 are communication signals for the decoded data. The state machine is sensitive for the positive edge of the clock 14. The reset input 13 is an asynchronous input.

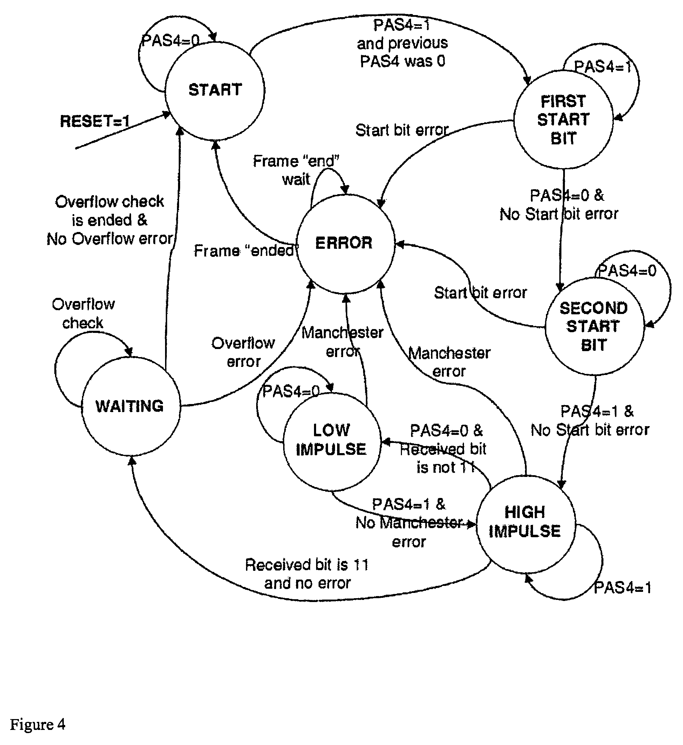

Fig. 4, finally, shows the state machine of the decoder 6 of fig. 3.

In the following, the different states of the state machine are described in greater detail.

### START state

If Reset 13 is active, the state machine goes in the START state. In the START state, the reset of a pulse width counter and the reset of a frame limiter counter are disabled. The low state and high state of the PAS4 signal 13 are detected. After this detection, the start of a data frame can be sensed. A frame in this embodiment is defined as containing the following thirteen bits:

| start bits | | word coding | | data bits (MSB first) | | | | | | | | parity |
|---|---|---|---|---|---|---|---|---|---|---|---|---|
| 0 | 0 | W2 | W1 | D7 | D6 | D5 | D4 | D3 | D2 | D1 | D0 | P0 |

More generally the bits W2, W1 and D[7..0] are the 10 transported data bits, which have to be output later at the UART output. The start bits are always 0 for synchronization purposes. The parity has to be even (that means the sum of all thirteen bits which are equal to 1 has to be even). Thirteen bits are received, but the start bits are not included because they are only for synchronizing.

### FIRST START BIT state

In this state, the pulse width counter and the frame limiter counter are enabled. The decoder algorithm counts only the pulse widths. Therefore, the error detection adapted thereto. Start bit error can be sensed if the first high pulse is too wide. If the first high pulse is narrower than a pre-stored limit for the width of the pulse, no Start bit error is generated, the pulse width counter is be disabled and the state machine goes to the next state.

### SECOND START BIT state

This state is essentially the same as the previous state. The difference is that the second pulse will be a low pulse. The width of the pulse is counted and if the pulse width exceeds a pre-stored limit, an error (Start bit error) is generated. If the pulse width is less than a pre-stored limit, the pulse is accepted and new limits will be calculated from the first and the second pulse width. These limits are subsequently used to distinguish between the half bit long and the one bit long pulses, to sense the Manchester errors, to give a new frame width limit, and to sense the overflow error.

### HIGH/LOW IMPULSE state

If the start bits are successfully received, the data bits can be received at the input 13. Under these states the pulse width counter counts the widths of the pulse. If the counter's value is higher than a Manchester error limit, or a one bit long pulse is sensed after an ignored half bit pulse, there is a Manchester error and an error signal is generated accordingly. Because between the different bits there will be no regular or usable pulse, some pulses must be ignored. There are two possible cases in which the pulse is usable:
a) the pulse is one bit long or
b) the pulse is half bit long but the previous pulse was a half bit long and it was ignored.

The value of the useful impulses will be saved. If the predetermined number of bits, preferred an uneven number, more preferred 11 bits, of one frame were successfully received, and there was no error, the next state will be the WAIT state. WAIT state

Under the WAIT state first an overflow check will be done. If there was no overflow error, the decoded data output 20 will be set and the data ready signal output 19 will be set to 1. A parity check is performed and if the parity bit is not correct, there parity error output will be set to 1. The pulse width counter and the frame width limiter counter will be disabled. Every saved value will be set to the initial preset value. The next state will be START state.

### ERROR state

If under the receiving the signal at the data input 13, a Start bit error, a Manchester error or an Overflow error has been detected, the state machine goes to this state. In this state, the frame width limiter is important. It counts until it reaches the limit. After that the decoded data output 20, the right error output and the data ready output 19 will be set. The data output bits are generated until any error has been detected. After the error, the remaining data bits assume their reset values (0).

The pulse width counter and the frame width limiter counter will be disabled. Every saved value will be set to the initial value. The next state will be START state.

As an improvement of the invention a glitch filter can be used. The glitch filter has an asynchronous reset input and is sensitive for the negative edge of the clock. After resetting the glitch filter, the output signal value will be zero. A comparator device compares the output value of the filtered signal which is sent from transmitter 2 through channel 3 with the unfiltered signal from transmitter 2 through channel 3 without passing the glitch filter. If the filtered signal is not equal to the non filtered signal, the non filtered signal holds its value. After one clock period time the comparator compares the filtered and the non filtered signals and if the signals are not equal, the non filtered signal takes the value, else the non filtered signal holds its value. With this filter one clock period time long glitch can be eliminated.

## Claims

1. Method of decoding a digital signal which is encoded as a code sequence in Manchester code and which is submitted as a sequence of frames by a data source and received by a decoder, **characterized in that** the decoder distinguishes between the high state and the low state of the signal by synchronizing itself both for the high halfbit and the low halfbit during the period of two start bits of the frame, and that the times t1, t2, calculated during the synchronization are used during the interpretation of the following bits of the frame, where t1 denotes the first duration time between a first signal level change and a second signal level change, the first and the second signal level change being in opposite directions, and where t2 denotes the second duration time between the second signal level change and a third signal level change, the second and the third signal level change being in opposite directions, the method further comprising the following steps:
a) determine the first duration time, t1, and the second duration time, t2, based on the two start bits,
b) compare the first duration time, t1, of step a) with a preset time first value, T1, and the second duration time, t2, with a preset time second value, T2;
c)
i) if the first duration time, t1, differs from the first value , T1, by more than a first threshold, dt1, or if the second duration time, t2, differs from the second value, T2, by more than a second threshold, dt2, then set an error flag, discard the present code sequence and request and/or expect a new code sequence to be submitted from the data source,
ii) if the first duration time, t1, differs from the first value, T1, by less than a first threshold, dt1, and if the second duration time, t2, differs from the second value, T2, by less than a second threshold, dt2, then the present code sequence will be accepted and decoded according to the Manchester code which is used for encoding, and after the acceptance of the code sequence, the preset time value, T1, T2, is replaced by the corresponding duration time, t1, t2, which was determined in step a), and a new code sequence is requested and/or expected from the data source and
d) proceed with step a).

2. Method according to claim 1, **characterized in that** a first duration time, t1, is determined each time between
a first signal level change and a second signal level change, and a second duration time, t2, is determined
each time between a second signal level change and a third signal level change and followed by the steps b) and c) according to claim 1 for every estimated duration time.

3. Method according to one of the preceding claims, **characterized in that** in step ci), the new code sequence is identical with the present sequence which was discarded.

4. Method according to one of the preceding claims, **characterized in that** in step c), the first and/or second threshold, dt1, dt2, is in the range of 0 to 1/4 of the corresponding preset time value T1, T2 , preferably 0 to
1/6 of the corresponding preset time value T1, T2 .

5. Method according to one of the preceding claims, **characterized in that** in step c), the first and/or second threshold dt1, dt2 is in the range of 0 to 1/10 of the corresponding preset time value T1, T2 .

6. Method according to one of the preceding claims, **characterized in that** in step c), for values of duration time t1, t2 which are smaller than the corresponding preset time value T1, T2 , i.e. t1 < T1 and t2 < T2, the corresponding threshold dt1, dt2, is in the range of 0 to 1/4 of the corresponding preset time value T1, T2 , preferably 0 to 1/6 of the corresponding preset time value T1, T2 , and for values of duration time t1, t2, which are greater than the corresponding preset time value T1, T2, i.e. t1 > T1 and t2 > T2, the threshold dt1, dt2 is in the range of 0 to the corresponding preset time value T1, T2 , preferably 0 to 1/2 of the corresponding preset time value T1, T2 , and more preferably 0 to 1/4 of the corresponding preset time value T1, T2.

7. A device with a memory, signal input means, signal output means and a micro processor or FPGA or ASIC, for the execution of the method according to claim 1.

8. An electric steering system in which a signal is Manchester encoded and decoded according to one of the preceding claims 1 - 6, wherein the signal is a torque signal from a torque sensor or an angular signal from a rotation angle sensor.

## Patentansprüche

1. Verfahren zum Decodieren eines digitalen Signals, das als eine Code-Folge in Manchester-Code encodiert ist und als eine Folge von Frames von einer Datenquelle übermittelt und von einem Decoder empfangen wird, **dadurch gekennzeichnet, dass** der Decoder zwischen dem hohen Zustand und dem tiefen Zustand des Signals unterscheidet, indem er sich sowohl für das hohe Halb-Bit als auch für das tiefe Halb-Bit während der Periode von zwei Startbits des Frame synchronisiert, und dadurch, dass die bei der Synchronisation berechneten Zeitpunkte t1, t2, während der Interpretation der folgenden Bits des Frame benutzt werden, wobei t1 die erste Zeitdauer zwischen einer ersten Signalpegeländerung und einer zweiten Signalpegeländerung bedeutet, wobei die erste und die zweite Signalpegeländerung in entgegengesetzten Richtungen erfolgen, und wobei t2 die zweite Zeitdauer zwischen der zweiten Signalpegeländerung und einer dritten Signalpegeländerung bedeutet, wobei die zweite und die dritte Signalpegeländerung in entgegengesetzten Richtungen erfolgen, wobei das Verfahren ferner die folgenden Schritte beinhaltet:
a) Ermitteln der ersten Zeitdauer t1 und der zweiten Zeitdauer t2 auf der Basis der beiden Startbits,
b) Vergleichen der ersten Zeitdauer t1 von Schritt a) mit einem voreingestellten ersten Zeitwert T1 und der zweiten Zeitdauer t2 mit einem voreingestellten zweiten Zeitwert T2;
c)
i) wenn sich die erste Zeitdauer t1 vom ersten Wert T1 um mehr als eine erste Schwelle dt1 unterscheidet oder wenn sich die zweite Zeitdauer t2 vom zweiten Wert T2 um mehr als eine zweite Schwelle dt2 unterscheidet, Setzen eines Fehlerflag, Verwerfen der aktuellen Code-Folge und Anfordern und/oder Erwarten einer zu übermittelnden neuen Code-Folge von der Datenquelle,
ii) wenn sich die erste Zeitdauer t1 vom ersten Wert T1 um weniger als eine erste Schwelle dt1 unterscheidet und wenn sich die zweite Zeitdauer t2 vom zweiten Wert T2 um weniger als eine zweite Schwelle dt2 unterscheidet, Akzeptieren der aktuellen Code-Folge und Decodieren derselben gemäß dem zum Encodieren benutzten Manchester-Code, und nach dem Akzeptieren der Code-Folge, Ersetzen, des voreingestellten Zeitwerts T1, T2 durch die in Schritt a) ermittelte entsprechende Zeitdauer t1, t2, und Anfordern und/oder Erwarten einer neuen Code-Folge von der Datenquelle, und
d) Fortfahren mit Schritt a).

2. Verfahren nach Anspruch 1, **dadurch gekennzeichnet, dass** eine erste Zeitdauer t1 jedes Mal zwischen einer ersten Signalpegeländerung und einer zweiten Signalpegeländerung ermittelt wird und eine zweite Zeitdauer t2 jedes Mal zwischen einer zweiten Signalpegeländerung und einer dritten Signalpegeländerung ermittelt wird, gefolgt von den Schritten b) und c) gemäß Anspruch 1 für jede geschätzte Zeitdauer.

3. Verfahren nach einem der vorherigen Ansprüche, **dadurch gekennzeichnet, dass** in Schritt ci) die neue Code-Folge mit der aktuellen Code-Sequenz, die verworfen wurde, identisch ist.

4. Verfahren nach einem der vorherigen Ansprüche, **dadurch gekennzeichnet, dass** in Schritt c) die erste und/oder die zweite Schwelle dt1, dt2 im Bereich von 0 bis 1/4 des entsprechenden voreingestellten Zeitwertes T1, T2, vorzugsweise von 0 bis 1/6 des entsprechenden voreingestellten Zeitwertes T1, T2 liegt/liegen.

5. Verfahren nach einem der vorherigen Ansprüche, **dadurch gekennzeichnet, dass** in Schritt c) die erste und/oder die zweite Schwelle dt1, dt2 im Bereich von 0 bis 1/10 des entsprechenden voreingestellten Zeitwertes T1, T2 liegt/liegen.

6. Verfahren nach einem der vorherigen Ansprüche, **dadurch gekennzeichnet, dass** in Schritt c), für Werte der Zeitdauer t1, t2, die kleiner sind als der entsprechende voreingestellte Zeitwert T1, T2, d.h. t1 < T1 und t2 < T2, die entsprechende Schwelle dt1, dt2 im Bereich von 0 bis 1/4 des entsprechenden voreingestellten Zeitwerts T1, T2, vorzugsweise von 0 bis 1/6 des entsprechenden voreingestellten Zeitwerts T1, T2 liegt, und für Werte der Zeitdauer t1, t2, die größer sind als der entsprechende voreingestellte Zeitwert T1, T2, d.h. t1 > T1 und t2 > T2, die Schwelle dt1, dt2 im Bereich von 0 bis zum entsprechenden voreingestellten Zeitwert T1, T2, vorzugsweise von 0 bis 1/2 des entsprechenden voreingestellten Zeitwertes T1, T2, bevorzugter von 0 bis 1/4 des entsprechenden voreingestellten Zeitwerts T1, T2 liegt.

7. Gerät mit einem Speicher, einem Signaleingabemittel, einem Signalausgabemittel und einem Mikroprozessor oder einer FPGA oder ASIC, zum Ausführen des Verfahrens nach Anspruch 1.

8. Elektrisches Steuersystem, in dem ein Signal Manchesterencodiert und -decodiert wird, gemäß einem der vorherigen Ansprüche 1 - 6, wobei das Signal ein Drehmomentsignal von einem Drehmomentsensor oder ein Winkelsignal von einem Drehwinkelsensor ist.

## Revendications

1. Procédé de décodage d'un signal numérique codé sous la forme d'une séquence de code Manchester, et transmis sous la forme d'une séquence de trames par une source de données et reçu par un décodeur, **caractérisé en ce que** le décodeur fait la distinction entre l'état haut et l'état bas du signal en se synchronisant aussi bien pour le demi-bit haut que pour le demi-bit bas pendant la période de deux bits de départ de la trame, et les temps t1 et t2 calculés pendant la synchronisation sont utilisés pendant l'interprétation des bits suivants de la trame, dans lequel t1 indique la première durée entre une première variation de niveau de signal et une deuxième variation de niveau de signal, les première et deuxième variations de niveau de signal étant dans des directions opposées, et dans lequel t2 indique la deuxième durée entre la deuxième variation de niveau de signal et une troisième variation de niveau de signal, les deuxième et troisième variations de niveau de signal étant dans des directions opposées, le procédé comprenant en outre les étapes suivantes consistant à :
a) déterminer la première durée t1 et la deuxième durée t2 en fonction des deux bits de départ,
b) comparer la première durée t1 de l'étape a) à une première valeur temporelle prédéfinie T1, et la deuxième durée t2 à une deuxième valeur temporelle prédéfinie T2,
c)
i) si la première durée t1 diffère de la première valeur T1 de plus d'une première valeur de seuil dt1, ou si la deuxième durée t2 diffère de la deuxième valeur T2 de plus d'une deuxième valeur de seuil dt2, positionner alors un drapeau d'erreur, rejeter la séquence de code actuelle et demander et/ou attendre une nouvelle séquence de code transmise par la source de données,
ii) si la première durée t1 diffère de la première valeur T1 de moins d'une première valeur de seuil dt1, et si la deuxième durée t2 diffère de la deuxième valeur T2 de moins d'une deuxième valeur de seuil dt2, la séquence de code actuelle est acceptée et décodée en fonction du code Manchester utilisé pour le codage et, après acceptation de la séquence de code, la valeur temporelle prédéfinie T1, T2 est remplacée par la durée correspondante t1, t2, laquelle a été déterminée à l'étape a), et une nouvelle séquence de code est demandée et/ou attendue en provenance de la source de données, et
d) passer à l'étape a).

2. Procédé selon la revendication 1, **caractérisé en ce qu'**une première durée t1 est déterminée à chaque fois entre une première variation de niveau de signal et une deuxième variation de niveau de signal, et une deuxième durée t2 est déterminée à chaque fois entre une deuxième variation de niveau de signal et une troisième variation de niveau de signal, avant de passer aux étapes b) et c) selon la revendication 1 pour chaque durée estimée.

3. Procédé selon l'une quelconque des revendications précédentes, **caractérisé en ce que,** à l'étape ci), la nouvelle séquence de code est identique à la séquence actuelle qui a été rejetée.

4. Procédé selon l'une quelconque des revendications précédentes, **caractérisé en ce que,** à l'étape c), la première et/ou la deuxième valeur de seuil dt1, dt2 est comprise dans la plage de 0 à 1/4 de la valeur temporelle prédéfinie correspondante T1, T2, de préférence, de 0 à 1/6 de la valeur temporelle prédéfinie correspondante T1, T2.

5. Procédé selon l'une quelconque des revendications précédentes, **caractérisé en ce que,** à l'étape c), la première et/ou la deuxième valeur de seuil dt1, dt2 est comprise dans la plage de 0 à 1/10 de la valeur temporelle prédéfinie correspondante T1, T2.

6. Procédé selon l'une quelconque des revendications précédentes, **caractérisé en ce que,** à l'étape c), pour des valeurs de durée t1, t2 inférieures à la valeur temporelle prédéfinie correspondante T1, T2, c.-à-d. t1 < T1 et t2 < T2, la valeur de seuil correspondante dt1, dt2 est comprise dans la plage de 0 à 1/4 de la valeur temporelle prédéfinie correspondante T1, T2, de préférence, de 0 à 1/6 de la valeur temporelle prédéfinie correspondante T1, T2, et pour des valeurs de durée t1, t2 supérieures à la valeur temporelle prédéfinie correspondante T1, T2, c.-à-d. t1 > T1 et t2 > T2, la valeur de seuil correspondante dt1, dt2 est comprise dans la plage de 0 à la valeur temporelle prédéfinie correspondante T1, T2, de préférence, de 0 à 1/2 de la valeur temporelle prédéfinie correspondante T1, T2 et, plus préférablement, dans la plage de 0 à 1/4 de la valeur temporelle prédéfinie correspondante T1, T2.

7. Dispositif comprenant une mémoire, des dispositifs d'entrée de signal, des dispositifs de sortie de signal, et un microprocesseur, un réseau de portes programmables ou un circuit intégré à application spécifique, permettant la mise en oeuvre du procédé selon la revendication 1.

8. Système de direction électrique, dans lequel un signal est codé et décodé en utilisant le codage Manchester selon l'une des revendications précédentes 1 à 6, et dans lequel le signal est un signal de couple provenant d'un capteur de couple ou un signal angulaire provenant d'un capteur d'angle de rotation.
